(19) Europäisches Patentamt
European Patent Office
Office européen des brevets

(11) **EP 2 741 390 B1**

(12) **FASCICULE DE BREVET EUROPEEN**

(45) Date de publication et mention
de la délivrance du brevet:
**11.02.2015 Bulletin 2015/07**

(51) Int Cl.:
***H02H 3/38*** *(2006.01)*   ***H02H 3/42*** *(2006.01)*

(21) Numéro de dépôt: **13191328.7**

(22) Date de dépôt: **04.11.2013**

(54) **Détection directionnelle d'un défaut, notamment dans un réseau à neutre compensé ou isolé**

Richtungserkennung einer Störung, insbesondere in einem Netz mit kompensiertem oder isoliertem Nulleiter

Directional detection of a fault, in particular in a network with compensated or insulated neutral

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.12.2012 FR 1261709**
**06.12.2012 FR 1261712**

(43) Date de publication de la demande:
**11.06.2014 Bulletin 2014/24**

(73) Titulaire: **Schneider Electric Industries SAS**
**92500 Rueil-Malmaison (FR)**

(72) Inventeurs:
• **CUMUNEL, Pascal**
**38050 GRENOBLE Cedex 01 (FR)**
• **VERNEAU, Guillaume**
**38050 GRENOBLE Cedex 09 (FR)**

(74) Mandataire: **Péru, Laurence**
**Schneider Electric Industries SAS**
**Service Propriété Industrielle**
**WTC-38EE1**
**5 pl. Robert Schuman**
**38050 Grenoble Cédex 09 (FR)**

(56) Documents cités:
**EP-A1- 0 573 333   WO-A1-2005/038474**
**WO-A1-2011/029464   DE-A1- 19 901 789**
**FR-A1- 2 058 166   US-A1- 2008 211 511**

# Description

## DOMAINE TECHNIQUE

L'invention concerne la détection directionnelle d'un défaut à la terre, notamment dans un réseau à neutre compensé, et dans le cas particulier du neutre isolé. En particulier, l'invention est relative à un procédé de détection d'un défaut à la terre dans un réseau permettant en outre de déterminer si le défaut est localisé en amont ou en aval du point de détection. Le procédé selon l'invention repose sur l'analyse du signal en régime établi après défaut.

Sous un autre aspect, l'invention concerne un dispositif de détection apte à mettre en oeuvre le procédé précédent. En particulier, le dispositif de détection directionnelle de défaut à la terre comprend des moyens permettant d'interpréter les signaux de courant et de tension après les perturbations transitoires générées par un défaut afin de lui donner une localisation relative.

L'invention concerne enfin un dispositif de signalisation de défaut et un relais de déclenchement comprenant des capteurs du courant et de la tension homopolaires du réseau et fournissant au dispositif de détection précédent les signaux permettant la signalisation, par exemple par voyant, ou le déclenchement d'un dispositif de coupure du réseau.

## ETAT DE LA TECHNIQUE

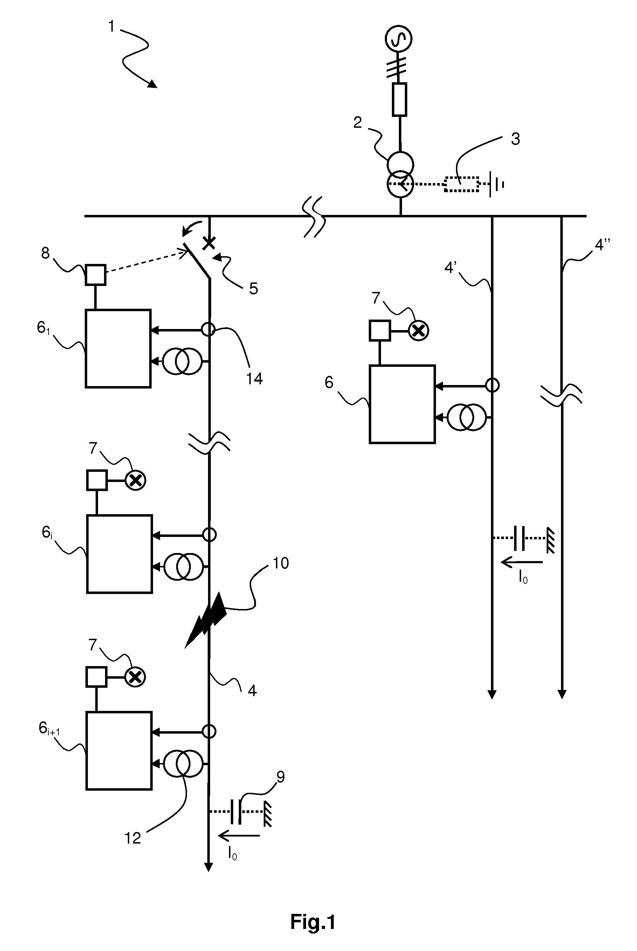

Les dispositifs de détection de défaut dans les réseaux triphasés permettent de déclencher la protection des charges et/ou d'aider à la localisation desdits défauts. Par exemple, la figure 1 représente un schéma d'un réseau 1 de distribution électrique moyenne tension qui comporte un transformateur 2 triphasé, dont le secondaire peut comporter un conducteur commun de neutre généralement connecté à la terre par une impédance 3 (dans le cas d'un réseau à neutre isolé, il n'existe pas de liaison physique entre le point neutre du réseau et la terre). Le secondaire est par ailleurs connecté à une ligne principale de distribution qui alimente des lignes de départ 4, 4', 4", dont certaines peuvent comporter en tête un disjoncteur ou autre dispositif de coupure 5 les protégeant.

Les lignes de départ 4, 4', 4", composées de lignes aériennes et/ou de câbles souterrains, peuvent être sujettes à des défauts variés, qu'il est important de détecter et localiser afin de pallier les problèmes générés : rupture d'alimentation, dégradation de la tenue des matériels d'isolation, sans compter la sécurité des personnes. Un dispositif de détection de défaut 6 installé sur les lignes de départ 4', ou des tronçons de ligne 4, peut servir d'indicateur de passage de défaut, allumant par exemple un voyant lumineux 7 ; un dispositif $6_1$ peut par ailleurs être associé ou intégré à un relais de protection 8 apte à commander l'ouverture des contacts du disjoncteur 5.

Parmi ces défauts, les plus fréquents sont les défauts monophasés, localisés hors du poste source, dans lesquels une phase est en contact avec la terre, ou la rupture d'un câble aérien en cas d'intempérie notamment. Or, entre les conducteurs de ligne 4 et la terre, en particulier si les lignes de départ 4 sont des câbles enterrés, peuvent apparaître des fortes valeurs de capacité 9, à l'origine de la circulation d'importants courants homopolaires $I_0$ en cas de défaut à la terre 10. Pour éviter une fausse détection d'un dispositif 6 de détection de défaut à la terre causée par une défaillance d'un départ voisin par liaison capacitive 9, des dispositifs et procédés ont été développés pour distinguer si un défaut 10 est localisé en aval du dispositif de détection $6_i$, ou en amont du dispositif $6_{i+1}$.

De plus, la mise à la terre 3 du secondaire du transformateur 2 peut elle-même être de nature à limiter l'amplitude d'un défaut terre 10 : sur les réseaux de distribution MT, on parle de défaut terre résistant (ou terre sensible) lorsque le niveau du courant de défaut est faible (et donc difficilement détectable), soit parce que la résistance de défaut est élevée, soit parce que la mise à la terre 3 du neutre au niveau du transformateur du poste source vient limiter ce courant de défaut (cas d'une bobine de compensation ou d'un neutre isolé par exemple), soit parce que le sol est lui-même de nature résistive. Des mesures plus fines du courant (« *sensitive earth fault* ») doivent être réalisées pour ces défauts très résistants.

Les documents EP 1475 874, EP 1 890 165, FR 2 936 319 ou WO 2006/136520 proposent des dispositifs et procédés pour détecter et localiser la direction de défauts à la terre, qui cependant reposent sur un échantillonnage important pendant la période transitoire de défaut. Le document FR 2 936 378 propose quant à lui une détermination à faible échantillonnage qui cependant n'est pas adaptée pour les câbles tripolaires, étant donné que le courant de chacune des phases n'y est pas disponible. Par ailleurs, dans tous ces cas, l'identification de la présence d'un défaut 10 est basée sur la détection de surintensités dans au moins une phase du réseau 1, et ce sur une durée minimale de défaut, ce qui peut être inapproprié pour les défauts terre sensibles, ou encore dans le cas de réseaux à neutre compensé ou isolé. Le document DE 199 01 789 propose de détecter et de localiser la direction de défauts à la terre sur la base du signe d'un produit effectué entre une valeur issue de la tension homopolaire et une valeur issue du courant homopolaire.

Il apparaît ainsi que les dispositifs de détection de défaut peuvent être optimisés.

## EXPOSE DE L'INVENTION

Parmi autres avantages, l'invention vise à pallier des inconvénients des dispositifs et procédés de détection directionnelle de défaut à la terre existants. En particulier, le principe de directionnalité mis en oeuvre repose sur l'analyse des paramètres du courant homopolaire en régime établi après défaut, qui reste malgré tout adapté pour les réseaux en régime de neutre compensé et/ou isolé, et qui ne nécessite pas un échantillonnage important des signaux représentatifs (typiquement, une fréquence d'échantillonnage inférieure à 1 kHz, par exemple de l'ordre de 500 ou 600 Hz, suffit), ce qui permet de pouvoir être mis en oeuvre dans des équipements ne disposant pas de mémoire importante au niveau software et/ou hardware.

Sous un de ses aspects, l'invention est relative à un procédé de détection directionnelle d'un défaut à la terre dans un réseau multiphasé, notamment à neutre compensé ou isolé, utilisant les signaux représentatifs de la tension et de la dérivée du courant homopolaire du réseau, et une évaluation du déphasage entre les deux signaux, notamment en le comparant à π, après que le procédé a été déclenché suite à l'obtention d'un signal indicateur de la présence d'un défaut à la terre. Le procédé selon l'invention comprend de préférence une étape préliminaire pour générer ledit signal indicateur de la présence de défaut, comprenant l'obtention d'un signal représentatif de la tension homopolaire du réseau et sa comparaison avec un seuil ; si cette étape est prévue, alors le signal représentatif de la tension homopolaire peut être utilisé également pour la détection directionnelle.

Le procédé selon l'invention comprend ainsi l'obtention de signaux représentatifs de la tension homopolaire, respectivement de la dérivée par rapport au temps du courant homopolaire, qui peuvent être issus du traitement direct de signaux représentatifs fournis par des capteurs dédiés, ou d'une étape de calcul desdits signaux à partir de la tension, respectivement du courant, obtenus pour chaque phase du réseau. De préférence, ces signaux sont filtrés, et/ou échantillonnés à une fréquence inférieure à 1 kHz, notamment de l'ordre de 600 Hz.

Pour évaluer le déphasage entre les deux signaux, le procédé peut comprendre la détermination de l'angle entre les signaux représentatifs de la tension et de la dérivée du courant homopolaire, et de préférence de son complémentaire à 180 ° ; l'angle ainsi déterminé est comparé à un paramètre fixé, notamment une gamme angulaire centrée sur 180°, ce qui revient à comparer son complémentaire à un seuil. Suivant le résultat de la comparaison, le procédé selon ce mode de réalisation de l'invention indique si le défaut est en amont ou en aval du point d'obtention des signaux, et notamment : si l'angle est proche de 180°, le défaut est considéré comme amont.

Dans le cas d'un régime à neutre isolé, le déphasage entre les signaux représentatifs de la tension et de la dérivée du courant homopolaire étant de 0 ou 180°, le procédé comprend de préférence la détermination du signe du produit entre les signaux représentatifs de la tension et de la dérivée du courant homopolaire pour indiquer si le défaut est en amont ou en aval du point d'obtention des signaux. Notamment, le procédé selon ce mode de réalisation de l'invention comprend le calcul du produit entre les signaux représentatifs de la tension et de la dérivée du courant homopolaire, et la comparaison de ce produit avec zéro : si le produit est négatif, le défaut est considéré comme amont.

Selon un mode de réalisation préféré du procédé selon l'invention, ledit procédé de détection directionnelle est associé à un actionnement d'un dispositif de coupure pour isoler le tronçon à partir du point en aval duquel un défaut a été détecté.

L'invention a par ailleurs pour objet un dispositif de détection directionnelle d'un défaut à la terre, adapté pour un réseau moyenne tension multiphasé, et notamment lorsque le réseau est à neutre compensé ou isolé. Le dispositif de détection directionnelle selon l'invention peut être associé à des capteurs de courant et de tension qui lui fournissent les signaux représentatifs correspondants. Le dispositif de détection directionnelle peut en outre faire partie d'un indicateur de passage de défaut, par exemple par activation de moyens d'alerte de type voyant si un défaut aval aux capteurs est détecté. Dans un mode de réalisation particulièrement préféré, le dispositif de détection directionnelle selon l'invention est associé à un relais de protection de la ligne, les moyens d'alerte provoquant l'actionnement d'un dispositif de coupure de la ligne permettant d'isoler le tronçon sur lequel un défaut a été détecté.

Le dispositif selon l'invention comprend un premier module apte à fournir un signal représentatif de la tension homopolaire du réseau ; de préférence, le premier module comprend des moyens pour recevoir le signal représentatif de la tension de chacune des phases et des moyens de sommation pour fournir ladite tension homopolaire. Le premier module peut comprendre des moyens d'échantillonnage, notamment à fréquence inférieure à 1 kHz, et/ou des moyens de filtrage comme un filtre analogique.

Le dispositif selon l'invention comprend un deuxième module apte à fournir un signal représentatif de la dérivée par rapport au temps du courant homopolaire. De préférence, le deuxième module comprend des moyens pour recevoir un signal représentatif du courant homopolaire et un bloc de dérivation ; les moyens pour recevoir un signal représentatif du courant homopolaire peuvent comprendre des moyens pour recevoir le signal représentatif du courant de chacune des phases et des moyens de sommation pour fournir ledit courant homopolaire. Le deuxième module peut comprendre des moyens d'échantillonnage, notamment à fréquence inférieure à 1 kHz, et/ou des moyens de filtrage comme un filtre analogique.

Le dispositif selon l'invention comprend en outre des moyens d'activation du deuxième module en fonction d'un signal de détection de l'occurrence du défaut. De préférence, le dispositif comprend des moyens pour fournir ledit signal de détection reliés au premier module et comprenant un comparateur du signal représentatif de la tension homopolaire à un seuil de détection.

Le dispositif selon l'invention comprend enfin un module de localisation relié aux premier et deuxième modules, comprenant des moyens d'évaluation par rapport à $\pi$ du déphasage entre la tension homopolaire et la dérivée du courant homopolaire. En particulier, les moyens d'évaluation du déphasage comprennent des moyens de détermination de l'angle entre la tension homopolaire et la dérivée du courant homopolaire, et des moyens pour comparer ledit angle à un paramètre fixé, qui est en particulier une plage de valeurs centrée sur 180° ; de préférence, le dispositif comprend alors des moyens de détermination du complémentaire à 180° dudit angle, et les moyens de comparaison sont adaptés pour comparer ledit complémentaire à un seuil. Dans le cas où le réseau est à neutre isolé, les moyens d'évaluation du déphasage peuvent être simplifiés et comprendre des moyens de détermination du signe du produit entre la tension homopolaire et la dérivée du courant homopolaire, de préférence des moyens de calcul dudit produit et des moyens pour comparer ce produit à zéro.

**BREVE DESCRIPTION DES FIGURES**

D'autres avantages et caractéristiques ressortiront plus clairement de la description qui suit de modes particuliers de réalisation de l'invention, donnés à titre illustratif et nullement limitatifs, représentés dans les figures annexées.

La figure 1, déjà décrite, représente un réseau électrique dans lequel des dispositifs de détection de défaut terre peuvent être utilisés.

La figure 2A montre de façon schématique et filtrée des signaux représentatifs des courants, dérivées du courant et tensions homopolaires, ainsi que l'angle relatif, lors de l'apparition d'un défaut à la terre respectivement à l'aval et à l'amont du dispositif de détection ; la figure 2B illustre le cas particulier du réseau à neutre isolé.

La figure 3 illustre le procédé de détection selon un mode de réalisation préféré de l'invention.

La figure 4 représente un schéma bloc d'un dispositif de détection de défaut terre selon un mode de réalisation préféré de l'invention.

**DESCRIPTION DETAILLEE D'UN MODE DE REALISATION PREFERE**

L'invention sera décrite pour un réseau triphasé équilibré 1 à neutre compensé ou isolé, dans lequel chaque ligne 4, 4', 4" comprend trois conducteurs de phase $4_A$, $4_B$, $4_C$ souterrains, le secondaire du transformateur 2 est relié à la terre par une bobine de Petersen 3, ou n'y étant pas relié (absence d'impédance 3 sur la figure 1), et le courant homopolaire $I_0$ est nul en l'absence de défaut. Par courant homopolaire $I_0$ (ou *« zero sequence current »* selon la terminologie anglo-saxonne), on entend, à un éventuel facteur trois près, la sommation vectorielle des différents courants de phase, ou encore le courant correspondant à la résultante instantanée des courants de phase, parfois appelé courant résiduel, qui correspond éventuellement au courant de défaut à la terre (*« ground default current »* selon la terminologie anglo-saxonne) ou au courant de fuite. Il est à noter qu'il est possible de s'écarter de cette situation, avec notamment un courant/une tension homopolaire non nul, et le réseau peut comprendre un autre nombre de phases ; par ailleurs, le régime de neutre peut ne pas être compensé.

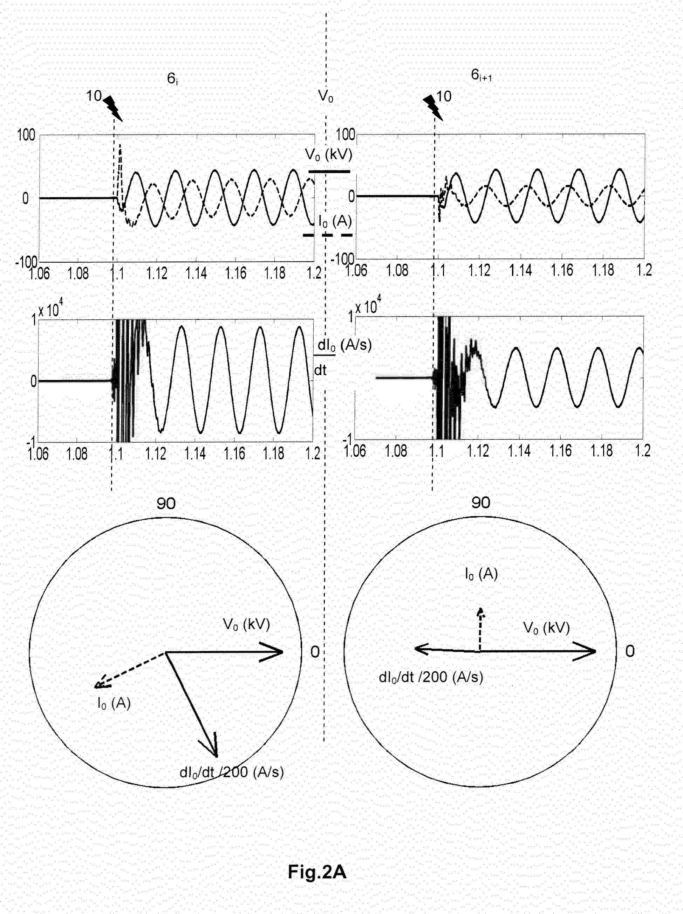

Lors de l'apparition d'un défaut à la terre 10 sur une des phases, le courant de ladite phase devient idéalement nul en aval du défaut 10 et voit son amplitude augmenter en amont : il y a donc apparition d'un courant et d'une tension homopolaires $I_0$, $V_0$ en aval du défaut 10. Cependant, tel qu'illustré en figure 2A, on note l'apparition fréquente d'un courant également en amont du défaut par liaison capacitive 9 ; de plus, après une période transitoire très brève, de l'ordre de 20 à 40 ms, la bobine de compensation 3 du point neutre ramène rapidement le courant de défaut $I_0$ à moins de 30 A crête, c'est-à-dire 20 A rms, valeur qui peut être difficile à détecter. En particulier, si la compensation du réseau est assez fine, la période transitoire est trop courte pour une détection fiable, et le courant homopolaire $I_0$ reste très faible en régime établi, en amont ou en aval : la détection de l'occurrence dudit défaut 10 nécessiterait une comparaison avec un seuil très bas, menant à des faux positifs, ou le défaut 10 n'est tout simplement pas identifié par la protection 6, 8.

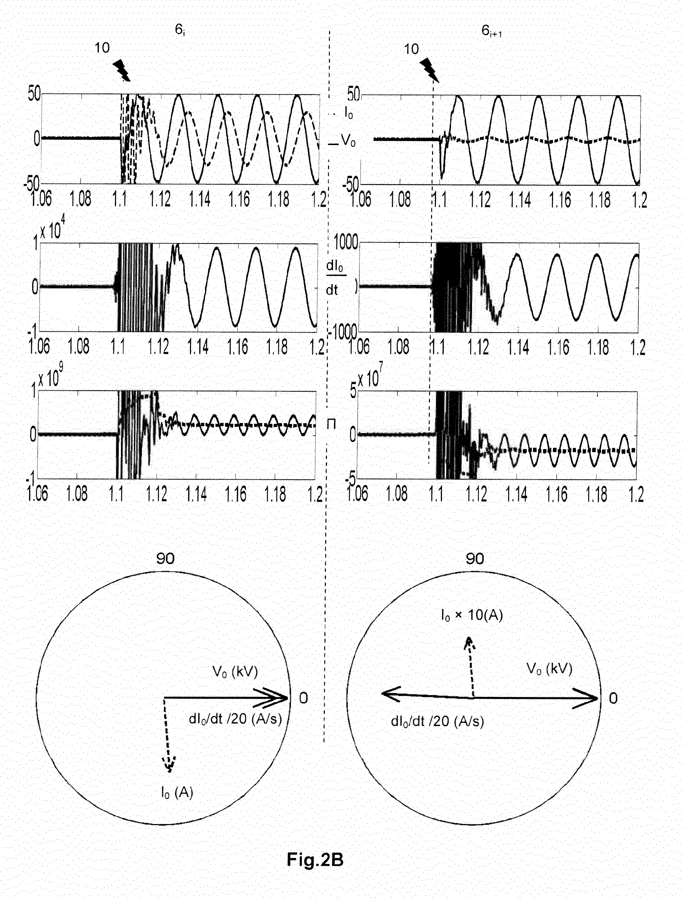

Dans le cas d'un neutre isolé illustré en figure 2B, le même phénomène se produit, avec un courant transitoire ayant pu atteindre 170 A crête mais sur une période trop courte pour une détection fiable : les seuls courants capacitifs qui circulent ensuite, dus aux conducteurs, soit de l'ordre de 2 à 4 A/km en souterrain et 0,08 A/km en aérien, génèrent un courant homopolaire $I_0$ lui aussi inférieur à 30 A crête,

Il est à noter que dans les deux cas, la tension V après défaut 10 reste quant à elle notable, la compensation générée par la bobine 3 n'étant pas parfaite, et l'isolement du neutre n'influant pas sur la tension V : en pratique, après la phase transitoire, et avant déclenchement de la protection 8 amont du départ 4, cette tension reste de l'ordre de plusieurs kilovolts (au moins 20 % de la tension de ligne), soit suffisante pour une détection en régime établi. L'invention se propose donc d'utiliser la mesure de la tension homopolaire $V_0$ pour la détection D d'un défaut terre, en comparant la valeur à un seuil $S_0$. La tension homopolaire $V_0$ peut être mesurée directement par un capteur approprié 12, ou calculée à partir de la mesure des tensions de phase $V_A$, $V_B$, $V_C$ réalisée par ailleurs par un équipement de protection de type VPIS (*« Voltage Presence Indicator System »*) localisé sur le transformateur 2.

Par ailleurs, bien que le courant homopolaire $I_0$ soit très faible en régime établi après défaut 10, l'invention se propose d'utiliser ce stade pour la localisation relative du défaut 10. De fait, les figures 2 montrent également que, selon que le défaut est en amont ou en aval du point de détection, après les perturbations transitoires, le déphasage entre la tension et le courant est différent : le déphasage de $I_0$ est en avance de $\pi/2$ sur $V_0$ en aval du défaut 10, alors que le déphasage est différent de $\pi/2$ en amont. Un traitement des données relatives à la tension homopolaire $V_0$ et au courant $I_0$ détecté par des capteurs adaptés 14 en régime établi est utilisé selon l'invention.

En particulier, l'invention utilise le signal correspondant à la dérivée du courant homopolaire $dI_0/dt$ en régime post-transitoire, ce qui permet :

- « d'agrandir » le signal $I_0$ de faible amplitude (en raison de la compensation par la bobine 3 de point neutre, ou généré la seule circulation de courants capacitifs en raison d'un régime isolé du neutre), en le multipliant par la pulsation angulaire $\omega$ du réseau 1, pour une meilleure perception ;
- de positionner directement ce signal $dI_0/dt$ par rapport à l'axe de la tension homopolaire $V_0$ : uniquement dans le cas d'un défaut en amont, les deux valeurs sont sur le même axe, aux erreurs de déphasage introduites par les capteurs 12, 14 près.

Dans le cas où le neutre est isolé, la figure 2B montre en outre que le déphasage de $I_0$ est en retard de $\pi/2$ en amont du défaut 10 : il devient alors possible de positionner directement ce signal $dI_0/dt$ par rapport à la tension homopolaire $V_0$ : du fait du décalage de 90° introduit par la dérivation, selon que le défaut est en amont ou en aval, les deux signaux $dI_0/dt$ et $V_0$ sont en phase ou en opposition de phase. Y compris dans le cas où un léger déphasage est présent en raison des capteurs ou des imprécisions des chaînes de mesure, cette situation correspond à un changement de signe dans le produit entre les deux signaux $\Pi = V_0 \times \dfrac{dI_0}{dt}$, ce qui est très simple à mettre en oeuvre.

Du fait de la détection en régime établi, il est possible d'utiliser un échantillonnage plus bas, notamment inférieur à 1 kHz, par exemple de 12 points par période (correspondant à une fréquence d'échantillonnage $f_{ech} = 600$ Hz pour un réseau 1 de fréquence F = 50 Hz), ce qui allège les calculs et diminue le coût des équipements comparé à l'échantillonnage haute fréquence, typiquement de 2500 à 3000 Hz, nécessaire pour une mesure en régime transitoire au début du défaut 10.

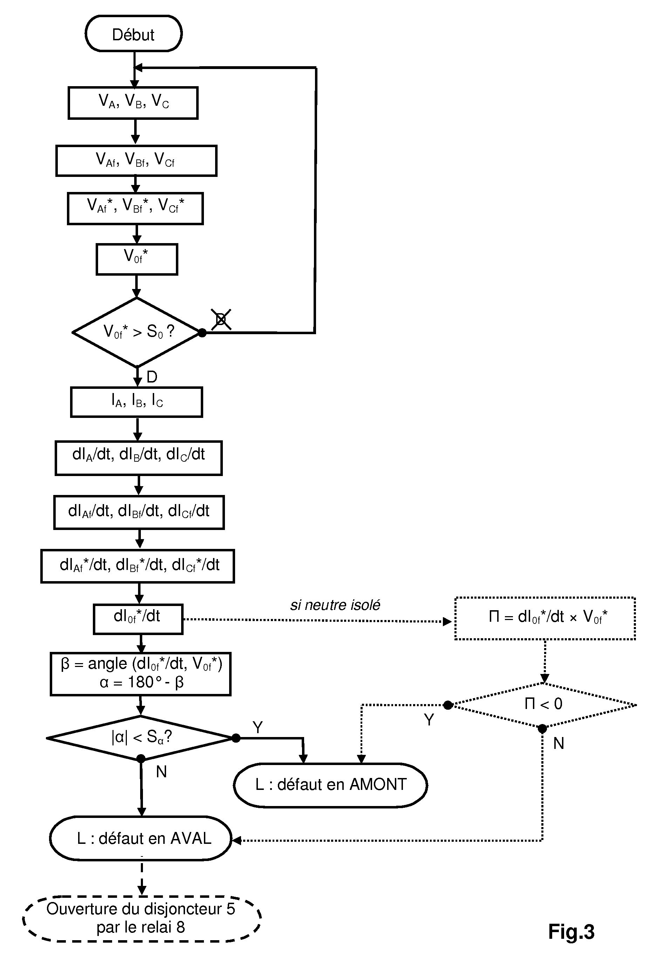

Ainsi, dans un procédé selon un mode de réalisation préféré selon l'invention schématisé en figure 3, dans un premier temps, un signal représentatif de la tension homopolaire $V_0$ est acquis, de préférence filtré $V_{0f}$. L'acquisition du signal peut être effectuée directement, via un capteur 12 dédié, ou par l'intermédiaire de la sommation de trois valeurs des tensions de phase $V_A$, $V_B$, $V_C$, signaux eux aussi de préférence filtrés et échantillonnés $V_{Af}^*$, $V_{Bf}^*$, $V_{Cf}^*$. Le signal de tension homopolaire est comparé à un seuil $S_0$ : si le seuil n'est pas dépassé, aucun défaut 10 n'est considéré comme présent sur la ligne 4 et le procédé de localisation n'est pas enclenché ; sinon, un défaut 10 est considéré comme détecté D.

Outre que tout moyen approprié peut donner une indication quant à la détection D, une fois le défaut 10 détecté, la dérivée par rapport au temps des signaux représentatifs des courants $I_A$, $I_B$, $I_C$ de phase est déterminée, par exemple par dérivation logicielle ou matérielle de signaux fournis par des capteurs de courant 14A, 14B, 14C. De préférence, les signaux représentatifs des dérivées des courants sont filtrés et échantillonnés, l'ordre de ces étapes pouvant être différent de celui indiqué (par exemple, le filtrage peut avoir lieu avant la dérivée). Les trois signaux sont additionnés de façon à obtenir un signal représentatif de la dérivée du courant homopolaire échantillonné filtré $dI_{0f}^*/dt$. Alternativement, le courant homopolaire $I_0$ pourrait être mesuré directement par l'intermédiaire d'un tore dédié 14, puis échantillonné, filtré et dérivé : une telle mesure directe du courant homopolaire est plus précise et permet d'éviter de cumuler les erreurs de capteurs lors de la sommation des mesures de chaque courant de ligne.

Pour obtenir une mesure fiable, il est préféré de mesurer le signal pendant deux périodes. De préférence, la même durée est utilisée pour l'acquisition de la tension homopolaire, mais ce n'est pas indispensable.

Du fait du décalage introduit par la dérivation du courant homopolaire $I_0$, le signal $dI_0/dt$ est en opposition de phase (180°) avec la tension $V_0$ dans le cas d'un défaut situé en amont de la détection, puisque dans ce cas le courant est d'origine capacitive 9. Le procédé comprend ainsi une étape de détermination du déphasage entre la dérivée du courant homopolaire $dI_0/dt$ et la tension homopolaire $V_0$, afin d'identifier s'il est égal à 180° ou non.

Plus précisément, l'étape de détermination du déphasage comprend classiquement une étape de détermination de l'angle $\beta$ entre la dérivée du courant homopolaire $dI_0/dt$ et la tension homopolaire $V_0$, ou de son complémentaire $\alpha = 180 - \beta$. Cette détermination peut être réalisée par toute méthode connue : mesure graphique ou logicielle ou calculatoire des passages des signaux par zéro, respectivement au minimum ou au maximum, ou représentation elliptique, ou même calcul de phaseur, etc., ou toute combinaison. Le complémentaire $\alpha$ de l'angle $\beta$ entre la dérivée de la tension homopolaire $dI_0/dt$ et la tension homopolaire $V_0$ est alors comparé à un seuil d'angle $S_\alpha$ : sous le seuil $S_\alpha$, l'angle $\alpha$ peut être considéré comme nul aux imprécisions dues aux capteurs près, et le défaut est localisé L comme en amont du point de mesure ; si l'angle $\alpha$ est supérieur au seuil, la localisation L indiquera le défaut comme en aval du point de mesure.

Le seuil $S_{\alpha}$ peut être déterminé en fonction de la précision $P_c$ des capteurs 12, 14 utilisés, et de la fréquence d'échantillonnage $f_{ech}$ retenue. De fait, dans le cas d'un échantillonnage à x points par période, chaque échantillon couvre un secteur angulaire de 360°/x, correspondant à une précision de $\pm$ 360°/2x : ainsi, l'amplitude du secteur angulaire autour de 180° entre les signaux considérés peut être considérée comme

$$\theta \le \max\left(P_C, \frac{360 \times F}{2 \times f_{ech}}\right) = S_{\alpha}$$, avec F fréquence du réseau 1, c'est-à-dire qu'un défaut amont correspond à $\beta \in [180 - S_{\alpha}, 180 + S_{\alpha}]$, ou $|\alpha| \le \theta_{max}$.

Il est possible que les capteurs de courant 14 et de tension 12 soient de nature à introduire eux-mêmes des déphasages (qui sont dans ce cas classiquement de $\pm$ 90° dans le cas de ponts inductif ou capacitif), ou que les signaux I et V soient obtenus par l'intermédiaire d'autres équipements introduisant eux aussi un déphasage : le principe décrit peut être facilement adapté en ajustant le seuil $S_{\alpha}$ de manière appropriée.

Dans le cas particulier où le régime de neutre est isolé, illustré en pointillés sur la figure 3, du fait du décalage introduit par la dérivation du courant homopolaire $I_0$, le signal $dI_0/dt$ est en opposition de phase (180°) avec la tension $V_0$ dans le cas d'un défaut situé en amont de la détection, puisque dans ce cas le courant est d'origine capacitive 9, mais reste en phase (décalage de 0°) lorsque le défaut 10 est en aval de la détection $6_i$. Le procédé peut être simplifié en ce que l'étape de détermination du déphasage comprend ainsi une étape de calcul du produit $\Pi$ entre la dérivée du courant homopolaire $dI_0/dt$ et la tension homopolaire $V_0$, ce calcul pouvantt être réalisé par toute méthode connue : multiplieur à amplificateur opérationnel, circuit intégré dédié ou multiplication logicielle. Le produit $\Pi$ ainsi calculé est alors comparé à zéro : il est supérieur à zéro dans le cas d'un défaut en aval, et inférieur dans le cas d'un défaut en amont ; alternativement, seul le signe du produit $\Pi$ est considéré : si le produit est positif, la localisation L indiquera que le défaut est en aval du point de mesure. Pour ce simple test de détermination de son signe, le produit $\Pi$ peut être calculé « au fil de l'eau », c'est-à-dire sur tous les échantillons issus des stades précédents, ou pris en considération sur sa valeur moyenne sur une durée de préférence supérieure à une période du réseau 1, par exemple de l'ordre de 20 ms. Dans le cas où les capteurs induisent eux-mêmes un déphasage, classiquement de $\pm$ 90° dans le cas de ponts inductif ou capacitif, une correction du signal représentatif est effectuée dans le premier ou deuxième module.

Le procédé selon l'invention peut être mis en place dans un relai de protection 8, dans un indicateur de défaut 6 avec système d'alerte 7, par implémentation dans un dispositif de détection directionnelle de défaut à la terre 100 adapté.

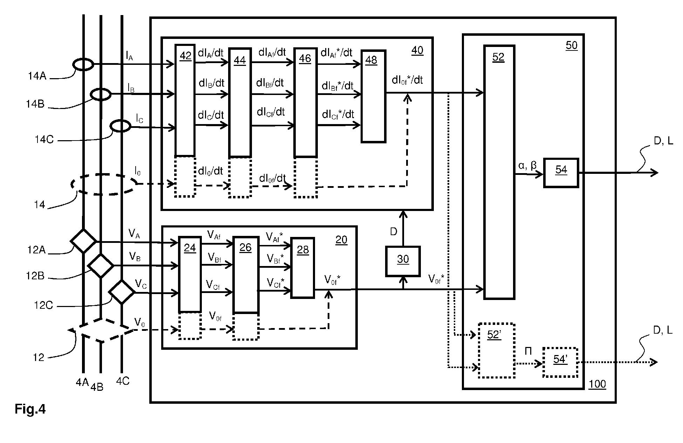

Un dispositif 100 selon un mode de réalisation préféré de l'invention est schématisé en figure 4. Il comprend un premier module 20 permettant d'obtenir un signal représentatif de la tension homopolaire $V_0$ à partir d'informations fournies par des capteurs de tension 12A, 12B, 12C adaptés, par exemple ceux du VPIS. Le premier module 20 comprend de préférence, dans un ordre indifférencié, des moyens 24 de filtrage des signaux $V_A$, $V_B$, $V_C$ comme un filtre analogique et des moyens 26 d'échantillonnage, fonctionnant avantageusement à moins de 1 kHz ; les signaux échantillonnés filtrés $V_{Af}^*$, $V_{Bf}^*$, $V_{Cf}^*$ sont traités par des moyens de sommation 28 permettant de déterminer la tension homopolaire $V_{0f}^*$. Alternativement, les moyens de sommation 28 peuvent être adaptés pour traiter directement les signaux reçus via les capteurs 12A, 12B, 12C, le filtrage et l'échantillonnage lui succédant.

Alternativement, si le réseau est muni d'un capteur 12 adapté, le signal représentatif de la tension homopolaire $V_0$ peut être reçu directement par le premier module 20 du dispositif 100 selon l'invention, dont les modules 24, 26 de filtrage et d'échantillonnage sont alors adaptés pour traiter le signal.

Le premier module 20 est ainsi apte à fournir une valeur $V_0$ de la tension homopolaire, et le dispositif selon l'invention comprend des moyens 30 de détection de défaut, notamment un module de comparaison de la tension homopolaire $V_0$ obtenue par le premier module 20 avec un seuil $S_0$. Si le seuil est dépassé, alors un défaut D est détecté : le dispositif 100 peut être muni de moyens pour indiquer le défaut, par exemple un indicateur lumineux ou sonore, des relais de contact ou une liaison de communication.

De plus, les moyens 30 de détection de défaut sont adaptés pour activer un deuxième module 40 du dispositif 100 selon l'invention permettant d'obtenir un signal représentatif de la dérivée par rapport au temps du courant homopolaire $I_0$. Le deuxième module 40 comprend un bloc de dérivation 42 pour déterminer la dérivée par rapport au temps des signaux représentatifs des courants de phase $I_A$, $I_B$, $I_C$ fournis par des capteurs 14A, 14B, 14C adaptés, par exemple des tores de détection. Dans le mode de réalisation illustré, les dérivées $dI_A/dt$, $dI_B/dt$, $dI_C/dt$ sont filtrées par des moyens adaptés 44 comme un filtre analogique, puis les signaux filtrés $dI_{Af}/dt$, $dI_{Bf}/dt$, $dI_{Cf}/dt$ sont conditionnés par échantillonnage via des moyens d'échantillonnage 46, fonctionnant avantageusement à moins de 1 kHz. Les signaux échantillonnés filtrés $dI_{Af}^*/dt$, $dI_{Bf}^*/dt$, $dI_{Cf}^*/dt$ sont traités par des moyens de sommation 48 du deuxième module 40 pour déterminer la dérivée du courant homopolaire $dI_{0f}^*/dt$.

Il est à noter que les différents moyens de traitement du deuxième module 40 peuvent être organisés différemment : notamment, les moyens de sommation 48 peuvent être adaptés pour traiter directement les signaux reçus depuis les capteurs 14A, 14C, 14B, le bloc de dérivation 42 pouvant alors lui succéder ; de même, le filtrage et l'échantillonnage peuvent être agencés différemment.

Alternativement, si le réseau est muni d'un capteur 14 adapté, le signal représentatif du courant homopolaire $I_0$ peut être reçu directement par le deuxième module 40 du dispositif 100 selon l'invention, dont les moyens 42, 44, 46 de dérivation, de filtrage et d'échantillonnage sont alors adaptés pour traiter le signal représentatif du courant homopolaire $I_0$ directement.

Les résultats des traitements des premier et deuxième modules 20, 40 sont communiqués à un module 50 de localisation relative du défaut 10. Le module de localisation 50 comprend des moyens d'évaluation du déphasage, et notamment des premiers moyens 52 de calcul de l'angle $\beta$ entre les deux valeurs fournies, à savoir la tension homopolaire $V_0$ et la dérivée du courant homopolaire $dI_0/dt$ ; avantageusement, les premiers moyens sont adaptés pour calculer le complémentaire $\alpha$, différence entre $\pi$ et $\beta$, dudit angle. Le module 50 comprend ensuite des moyens de comparaison 54 pour déterminer la localisation relative, par exemple des moyens permettant de comparer à un seuil $S_\alpha$ la valeur de l'angle complémentaire $\alpha$, et la communiquer.

Lorsque le dispositif selon l'invention est destiné à une utilisation sur un réseau à neutre compensé, alternativement, les moyens d'évaluation du déphasage du module de localisation 50 peuvent comprendre des seconds moyens 52' de calcul du produit $\Pi$ entre les deux valeurs fournies, à savoir la tension homopolaire $V_0$ et la dérivée du courant homopolaire $dI_0/dt$, puis des moyens de comparaison 54' pour déterminer la localisation relative, par exemple des moyens permettant de comparer à zéro ledit produit, et la communiquer.

Il est possible éventuellement de prévoir les deux alternatives de détermination du déphasage au sein d'un même module 50 pour un même appareil 100, avec par exemple un système de sélection pour l'une ou l'autre des voies selon la destination finale du dispositif de localisation 100 sur site.

Le dispositif 100 de la figure 4 peut être avantageusement associé à un relai de protection 8 pour des réseaux électriques, ou à un indicateur de passage de défaut pour des lignes 4 moyenne tension souterraines ou aériennes connectées en réseau 1, la sortie du module de localisation 50 déclenchant la coupure d'un disjoncteur 5, l'allumage d'un voyant ou tout autre moyen de sécurité et/ou d'alerte.

Le procédé et le dispositif selon l'invention permettent donc :

- une détection directionnelle de défaut terre sur un réseau moyenne tension 1, y compris à neutre compensé et à neutre isolé, sur la base des informations de tension homopolaire et courant homopolaire ;
- une détection directionnelle de défaut terre sans besoin d'échantillonnage haute fréquence du fait de l'utilisation des caractéristiques du réseau 1 en régime établi après défaut, et non en régime transitoire ;

- une détection directionnelle de défaut terre qui s'affranchit des problématiques de seuil de réglage, de niveau de courant capacitif selon les départs 4, et évite de « manquer » des défauts en cas de compensation précise du réseau 1, du fait de son initiation sur un seuil de tension homopolaire, et non sur le courant homopolaire ;
- une détection directionnelle de défaut terre qui permet une amplification des données véhiculées par le courant en exploitant la dérivée du courant homopolaire et non le courant proprement dit ;
- une détection directionnelle de défaut terre qui permet la simplification des calculs et traitement des signaux, du fait de l'utilisation de la dérivée du courant homopolaire qui permet d'aligner cette grandeur directement dans l'axe de la tension homopolaire dans le cas d'un défaut en amont du dispositif, en évitant le recours au calcul des phaseurs de courants et tensions ou de l'angle de polarisation pour définir un plan de déclenchement amont/aval ;
- un détection directionnelle de défaut terre d'autant plus simple à mettre en oeuvre dans le cas d'un réseau à neutre isolé du fait de l'utilisation du seul produit entre la dérivée du courant homopolaire et la tension homopolaire, et la vérification de son signe.

Bien que dans son mode d'implémentation général, l'invention ait été décrite en référence à un réseau de distribution triphasé dans lequel le neutre est mis à la terre par impédance compensée, elle ne s'y limite pas : d'autres types de réseaux multiphasés peuvent être concernés par l'invention ; en particulier, tout régime de neutre est approprié.

Par ailleurs, bien que décrit avec détermination et traitement de la tension homopolaire instantanée $V_0$ pour la détection du défaut, le procédé selon l'invention peut utiliser la variation de ladite tension $V_0$ par rapport à sa valeur déterminée sur une période préalable : cette variante s'avère particulièrement intéressante dans le cas de réseaux présentant un léger déséquilibre entre phases, dont la tension homopolaire $V_0$ est donc non nulle en situation hors défaut.

De fait, les différents circuits, modules et fonctions présentés dans le cadre du mode de réalisation préféré de l'invention peuvent être réalisés en composants analogiques, numériques ou sous une forme programmable opérant avec des microcontrôleurs ou des microprocesseurs, et les signaux représentatifs décrits peuvent avoir des formes de signaux électriques ou électroniques, de valeurs de données ou d'information dans des mémoires ou des registres, de signaux optiques visualisables notamment sur des voyants ou des écrans, ou de signaux mécaniques agissant avec des actionneurs. De même, les capteurs de courant peuvent être différents des tores décrits, comme des capteurs à effet Hall ou à effet Faraday, ou des magnétorésistances ; la tension peut être détectée par transformateurs de potentiel, diviseur capacitif, diviseur résistif, encore par des capteurs à effet Pockels.

## Revendications

1. Dispositif (100) de détection directionnelle d'un défaut à la terre (10) dans un réseau moyenne tension multiphasé (1) comportant :

   - un premier module (20) apte à fournir un signal représentatif de la tension homopolaire ($V_0$) de l'ensemble des phases ;
   - un deuxième module (40) apte à fournir un signal représentatif de la dérivée par rapport au temps du courant homopolaire ($I_0$) ;
   - des moyens d'activation dudit deuxième module (40) en fonction d'un signal (D) de détection de l'occurrence d'un défaut à la terre dans le réseau (1) ;
   - un module de localisation (50) comprenant des moyens d'évaluation par rapport à $\pi$ du déphasage entre la tension homopolaire ($V_0$) fournie par le premier module (20) et la dérivée du courant homopolaire ($dI_0/dt$) fournie par le deuxième module (40).

2. Dispositif de détection directionnelle (100) selon la revendication 1 dans lequel les moyens d'évaluation du déphasage comprennent des moyens de détermination (52) de l'angle ($\beta$) entre la tension homopolaire ($V_0$) fournie par le premier module (20) et la dérivée du courant homopolaire ($dI_0/dt$) fournie par le deuxième module (40), respectivement de complémentaire ($\alpha$) à 180° dudit angle ($\beta$), et des moyens de comparaison (54) dudit angle ($\beta$), respectivement dudit complémentaire ($\alpha$), avec un paramètre fixé pour déterminer si le défaut est en amont ou en aval du dispositif (100).

3. Dispositif de détection directionnelle (100) selon l'une des revendications 1 à 2 dans lequel les moyens d'évaluation par rapport à $\pi$ du déphasage entre la tension homopolaire ($V_0$) fournie par le premier module (20) et la dérivée du courant homopolaire ($dI_0/dt$) fournie par le deuxième module (40) comprennent, pour un réseau moyenne tension à neutre isolée, des moyens (52') de calcul du produit ($\Pi$) entre la tension homopolaire ($V_0$) fournie par le premier module (20) et la dérivée du courant homopolaire ($dI_0/dt$) fournie par le deuxième module (40), et des moyens (54') de comparaison dudit produit ($\Pi$) avec zéro.

4. Dispositif de détection directionnelle (100) selon l'une des revendications 1 à 3 dans lequel le premier module (20) comprend des moyens pour recevoir le signal représentatif de la tension ($V_A$, $V_B$, $V_C$) de chacune des phases du réseau (1) et des moyens de sommation (28) pour fournir ladite tension homopolaire ($V_0$).

5. Dispositif de détection directionnelle (100) selon l'une des revendications 1 à 4 dans lequel le deuxième module (40) comprend des moyens pour recevoir un signal représentatif d'un courant (I) du réseau (1) et un bloc de dérivation (42) adapté pour fournir la dérivée par rapport au temps ($dI/dt$) d'un signal représentatif d'un courant (I).

6. Dispositif de détection directionnelle (100) selon la revendication 5 dans lequel les moyens pour recevoir un signal représentatif d'un courant sont adaptés pour recevoir le signal représentatif du courant ($I_A$, $I_B$, $I_C$) de chacune des phases du réseau (1) et dans lequel le deuxième module (40) comprend des moyens de sommation (48) pour fournir un signal représentatif du courant homopolaire ($I_0$).

7. Dispositif de détection directionnelle (100) selon l'une des revendications 1 à 6 comprenant en outre des moyens (30) de détection de l'occurrence d'un défaut à la terre dans le réseau reliés au premier module (20) et aux moyens d'activation du deuxième module (40), lesdits moyens de détection (30) comprenant un comparateur du signal représentatif de la tension homopolaire ($V_0$) à un seuil de détection ($S_0$).

8. Indicateur de passage de défaut à la terre (6) comprenant des capteurs de courant et de tension (12, 12A, 12B, 12C, 14, 14A, 14B, 14C) disposés sur une ligne (4, 4A, 4B, 4C) d'un réseau électrique (1) à surveiller et comprenant un dispositif de détection directionnelle de défaut (100) selon l'une des revendications 1 à 7 connecté auxdits capteurs (12, 12A, 12B, 12C, 14, 14A, 14B, 14C) pour recevoir les signaux représentatifs de courant et tension.

9. Relais (9) de protection à la terre comprenant au moins un indicateur de passage de défaut selon la revendication 8 et des moyens d'actionnement d'un dispositif de coupure (5) en fonction des résultats du module de localisation (50) du dispositif de détection directionnelle (100) de l'indicateur.

10. Procédé de détection directionnelle (D, L) d'un défaut à la terre (10) dans un réseau multiphasé (1) comprenant le déclenchement, suite à l'obtention d'un signal (D) indicateur de la présence dudit défaut à la terre (10), de la détermination directionnelle (L) du défaut (10), ladite détection directionnelle comprenant les étapes successives de :

- obtention de signaux représentatifs de la tension homopolaire ($V_0$) et de la dérivée par rapport au temps du courant homopolaire ($dI_0/dt$) ;
- évaluation par rapport à 180° du déphasage entre les signaux représentatifs de la tension homopolaire ($V_0$) et de la dérivée par rapport au temps du courant homopolaire ($dI_0/dt$).

11. Procédé de détection directionnelle selon la revendication 10 dans lequel l'évaluation du déphasage comprend les étapes de :

- détermination de l'angle ($\beta$) entre les signaux représentatifs de la tension homopolaire ($V_0$) et de la dérivée par rapport au temps du courant homopolaire ($dI_0/dt$), respectivement du complémentaire ($\alpha$) à 180° dudit angle ($\beta$) ;
- comparaison dudit angle ($\beta$), respectivement du complémentaire ($\alpha$), avec un paramètre fixé pour indiquer si le défaut détecté (D) se situe en aval ou en amont de l'endroit où les signaux représentatifs ont été obtenus.

12. Procédé de détection directionnelle selon la revendication 10 dans lequel le réseau est à neutre isolé, et dans lequel l'évaluation par rapport à 180° du déphasage entre les signaux représentatifs de la tension homopolaire ($V_0$) et de la dérivée par rapport au temps du courant homopolaire ($dI_0/dt$) comprend les étapes de calcul du produit ($\Pi$) entre les signaux représentatifs de la tension homopolaire ($V_0$) et de la dérivée par rapport au temps du courant homopolaire ($dI_0/dt$) et la comparaison avec zéro dudit produit ($\Pi$).

13. Procédé de détection directionnelle selon l'une des revendication 10 à 12 dans lequel le signal (D) indicateur de la présence d'un défaut à la terre (10) est obtenu par la comparaison du signal de tension homopolaire ($V_0$) à un seuil de détection de défaut ($S_0$).

14. Procédé de détection directionnelle selon l'une des revendications 10 à 13 dans lequel l'obtention de signaux représentatifs de la tension homopolaire ($V_0$) et de la dérivée par rapport au temps du courant homopolaire ($dI_0/dt$) comporte un échantillonnage à fréquence inférieure à 1 kHz.

15. Procédé de protection d'une ligne de courant (5) lors de l'apparition d'un défaut à la terre (10) comprenant l'actionnement d'un dispositif de coupure (6) de ladite ligne (5) si un défaut à la terre (10) a été détecté par un procédé selon l'une des revendications 10 à 14 à l'aval dudit dispositif de coupure (6).

## Patentansprüche

1. Einrichtung (100) zur richtungsselektiven Erkennung eines Erdschlusses (10) in einem Mehrphasen-Mittelspannungsnetz (1), umfassend

- ein erstes Modul (20) zur Lieferung eines die Nullspannung ($V_0$) der Phasenanordnung abbildenden Signals,
- ein zweites Modul (40) zur Lieferung eines das Differential des Nullstroms ($I_0$) über die Zeit abbildenden Signals,
- Mittel zur Aktivierung des zweiten Moduls (40) in Abhängigkeit von einem das Auftreten eines Erdschlusses im Netz (1) anzeigenden Signal (D) sowie
- ein Lokalisierungsmodul (50) mit Auswertemitteln zur Auswertung der Phasenverschiebung zwischen der vom ersten Modul (20) gelieferten Nullspannung ($V_0$) und dem vom zweiten Modul (40) gelieferten Differential des Nullstroms ($dI_0/dt$) in Bezug zu $\pi$.

2. Einrichtung zur richtungsselektiven Erdschlusserkennung (100) nach Anspruch 1, bei der die Auswertemittel zur Auswertung der Phasenverschiebung Bestimmungsmittel (52) zur Bestimmung des Phasenwinkels ($\beta$) zwischen der vom ersten Modul (20) gelieferten Nullspannung ($V_0$) und dem vom zweiten Modul (4) gelieferten Differential des Nullstroms ($dI_0/dt$) bzw. des 180°-Komplementärwinkels ($\alpha$) des genannten Phasenwinkels ($\beta$) sowie Vergleichsmittel (54) zum Vergleich des genannten Winkels ($\beta$) bzw. des genannten Komplementärwinkels ($\alpha$) mit einem festen Wert umfassen, um zu bestimmen, ob der Erdschluss auf der Einspeiseseite oder der Abgangsseite der Einrichtung (100) aufgetreten ist.

3. Einrichtung zur richtungsselektiven Erdschlusserkennung (100) nach einem der Ansprüche 1 bis 2, bei der die Auswertemittel zur Auswertung der Phasenverschiebung zwischen der vom ersten Modul (20) gelieferten Nullspannung ($V_0$) und dem vom zweiten Modul (40) gelieferten Differential des Stroms ($dI_0/dt$) in Bezug zu $\pi$ für ein Mittelspannungsnetz mit isoliertem Sternpunkt Berechnungsmittel (52') zur Berechnung des Produkts ($\Pi$) aus der vom ersten Modul (20) gelieferten Nullspannung ($V_0$) und dem vom zweiten Modul (40) gelieferten Differential des Nullstroms ($dI_0/dt$) sowie Vergleichsmittel (54') zum Vergleich des genannten Produkts ($\Pi$) mit Null umfassen.

4. Einrichtung zur richtungsselektiven Erdschlusserkennung (100) nach einem der Ansprüche 1 bis 3, bei der das erste Modul (20) Mittel zur Erfassung des die Spannung ($V_A$, $V_B$, $V_C$) jeder Phase des Leitungsnetzes (1) abbildenden Signals sowie Summenbildungsmittel (28) zur Lieferung der genannten Nullspannung ($V_0$) umfasst.

5. Einrichtung zur richtungsselektiven Erdschlusserkennung (100) nach einem der Ansprüche 1 bis 4, bei der das zweite Modul (40) Mittel zur Erfassung eines einen Strom (I) des Leitungsnetzes (1) abbildenden Signals sowie einen Differentiatorblock (42) umfasst, welcher Block dazu ausgelegt ist, das Differential eines einen Strom (I) abbildenden Signals über die Zeit (dI/dt) zu liefern.

6. Einrichtung zur richtungsselektiven Erdschlusserkennung (100) nach Anspruch 5, bei der die Mittel zur Erfassung eines einen Strom abbildenden Signals dazu ausgelegt sind, das Signal zu erfassen, das den in jeder Phase des Leitungsnetzes (1) fließenden Strom ($I_A$, $I_B$, $I_C$) abbildet, und bei der das zweite Modul (40) Summenbildungsmittel (48) zur Lieferung eines den Nullstrom ($I_0$) abbildenden Signals umfasst.

7. Einrichtung zur richtungsselektiven Erdschlusserkennung (100) nach einem der Ansprüche 1 bis 6, die zusätzlich an das erste Modul (20) sowie an die Aktivierungsmittel zur Aktivierung des zweiten Moduls (40) angeschlossene Detektionsmittel (30) zur Erkennung eines Erdschlusses im Leitungsnetz umfasst, welche Detektionsmittel (30) einen Komparator zum Vergleich des die Nullspannung ($V_0$) abbildenden Signals mit einem Detektions-Schwellwert ($S_0$) umfassen.

8. Erdschlussanzeiger (6), der in eine Leitung (4, 4A, 4B, 4C) eines zu überwachenden Leitungsnetzes (1) geschaltete Strom- und Spannungswandler (12, 12A, 12B, 12C, 14, 14A, 14B, 14C) sowie eine Einrichtung zur richtungsselektiven Erdschlusserkennung (100) nach einem der Ansprüche 1 bis 7 umfasst, welche Einrichtung an die genannten Wandler (12, 12A, 12B, 12C, 14, 14A, 14B, 14C) angeschlossen ist, um die Strom und Spannung abbildenden Signale zu erfassen.

9. Erdschluss-Schutzrelais (9) mit mindestens einem Erdschlussanzeiger nach Anspruch 8 sowie mit Aktivierungsmitteln zur Aktivierung einer Abschaltvorrichtung (5) in Abhängigkeit von den Ergebnissen des Lokalisierungsmoduls (50) der Einrichtung zur richtungsselektiven Erdschlusserkennung (100) des Anzeigers.

10. Verfahren zur richtungsselektiven Erkennung (D, L) eines Erdschlusses (10) in einem Mehrphasen-Leitungsnetz (1), welches Verfahren die Schutzauslösung nach erfolgter Erfassung eines das Auftreten des genannten Erdschlusses (10) anzeigenden Signals und richtungsselektiver Bestimmung (L) des Erdschlusses (10) umfasst, wobei die genannte richtungsselektive Erdschlusserkennung folgende Schritte umfasst:

- Erfassung von die Nullspannung ($V_0$) und das Differential des Nullstroms über die Zeit ($dI_0/dt$) abbildenden Signalen,
- Auswertung der Phasenverschiebung zwischen den die Nullspannung ($V_0$) und das Differential des Nullstroms über die Zeit ($dI_0/dt$) abbildenden Signalen in Bezug zu 180°.

11. Verfahren zur richtungsselektiven Erdschlusserkennung nach Anspruch (10), bei dem die Auswertung der Phasenverschiebung folgende Schritte umfasst:

- Bestimmung des Winkels ($\beta$) zwischen den die Nullspannung ($V_0$) und das Differential des Nullstroms über die Zeit ($dI_0/dt$) abbildenden Signalen bzw. des 180°-Komplementär-winkels ($\alpha$) des genannten Winkels ($\beta$),
- Vergleich des genannten Winkels ($\beta$) bzw. des Komplementärwinkels ($\alpha$) mit einem festen Wert, um anzuzeigen, ob der erkannte Erdschluss (D) auf der Einspeiseseite oder der Abgangsseite des Ortes vorliegt, an dem die abbildenden Signale erfasst wurden.

12. Verfahren zur richtungsselektiven Erdschlusserkennung nach Anspruch 10, bei dem das Leitungsnetz als Netz mit isoliertem Sternpunkt ausgeführt ist und bei dem die Auswertung der Phasenverschiebung zwischen den die Nullspannung ($V_0$) und das Differential des Nullstroms ($dI_0/dt$) abbildenden Signalen in Bezug zu 180° die Schritte zur Berechnung des Produkts ($\Pi$) aus den die Nullspannung ($V_0$) und das Differential des Nullstroms über die Zeit ($dI_0/dt$) abbildenden Signalen und zum Vergleich des genannten Produkts ($\Pi$) mit Null umfasst.

13. Verfahren zur richtungsselektiven Erdschlusserkennung nach einem der Ansprüche 10 bis 12, bei dem das Signal (D) zur Anzeige des Vorliegens eines Erdschlusses (10) durch Vergleich des Nullspannungssignals ($V_0$) mit einem Erdschlusserkennungs-Schwellwert ($S_0$) gewonnen wird.

14. Verfahren zur richtungsselektiven Erdschlusserkennung nach einem der Ansprüche 10 bis 13, bei dem die Erfassung von die Nullspannung ($V_0$) und das Differential des Nullstroms über die Zeit ($dI_0/dt$) abbildenden Signalen eine Abtastung mit einer Frequenz unter 1 kHz umfasst.

15. Verfahren zum Schutz einer Stromleitung (5) bei Auftreten eines Erdschlusses (10), das die Betätigung einer Abschaltvorrichtung (6) umfasst, welche die genannte Stromleitung (5) abschaltet, wenn durch ein Verfahren nach einem der Ansprüche 10 bis 14 ein Erdschluss auf der Abgangsseite der genannten Abschaltvorrichtung (6) erkannt wurde.

## Claims

1. Device (100) for the directional detection of a ground fault (10) in a medium-voltage multiphase network (1), comprising:

    - a first module (20) able to provide a signal representative of the homopolar voltage ($V_0$) of all phases;
    - a second module (40) able to provide a signal representative of the derivative in relation to time of the homopolar current ($I_0$);
    - means for activating said second module (40) depending on a signal (D) of detection of the occurrence of a ground fault in the network (1);
    - a locating module (50), comprising means for evaluating, in relation to $\pi$, the phase shift between the homopolar voltage ($V_0$) provided by the first module (20) and the derivative of the homopolar current ($dI_0/dt$) provided by the second module (40).

2. Directional detection device (100) according to Claim 1, wherein the means for evaluating the phase shift comprise means (52) for determining the angle ($\beta$) between the homopolar voltage ($V_0$) provided by the first module (20) and the derivative of the homopolar current ($dI_0/dt$) provided by the second module (40), or respectively the complement ($\alpha$) to 180° of said angle ($\beta$), and means (54) for comparing said angle ($\beta$), or respectively said complement ($\alpha$), with a fixed parameter in order to determine whether the fault is upstream or downstream of the device (100).

3. Directional detection device (100) according to Claim 1 or 2, wherein the means for evaluating, in relation to $\pi$, the phase shift between the homopolar voltage $V_0$ provided by the first module (20) and the derivative of the homopolar current ($dI_0/dt$) provided by the second module (40) comprise, for a medium-voltage network with isolated neutral, means (52') for calculating the product ($\Pi$) between the homopolar voltage ($V_0$) provided by the first module (20) and the derivative of the homopolar current ($dI_0/dt$) provided by the second module (40), and means (54') for comparing said product ($\Pi$) with zero.

4. Directional detection device (100) according to one of Claims 1 to 3, wherein the first module (20) comprises means for receiving the signal representative of the voltage ($V_A$, $V_B$, $V_C$) of each of the phases of the network (1) and summation means (28) for providing said homopolar voltage ($V_0$).

5. Directional detection device (100) according to one of Claims 1 to 4, wherein the second module (40) comprises means for receiving a signal representative of a current (I) of the network (1) and a derivation block (42) suitable for providing the derivative in relation to time ($dI/dt$) of a signal representative of a current (I).

6. Directional detection device (100) according to Claim 5, wherein the means for receiving a signal representative of a current are suitable for receiving the signal representative of the current ($I_A$, $I_B$, $C_C$) of each of the phases of the network (1), and wherein the second module (40) comprises summation means (48) for providing a signal representative of the homopolar current ($I_0$).

7. Directional detection device (100) according to one of Claims 1 to 6, further comprising means (30) for detecting the occurrence of a ground fault in the network, said means being connected to the first module (20) and to the means for activating the second module (40), said detection means (30) comprising a comparator for comparing the signal representative of the homopolar voltage ($V_0$) to a detection threshold ($S_0$).

8. Ground fault passage indicator (6) comprising current and voltage sensors (12, 12A, 12B, 12C, 14, 14A, 14B, 14C) arranged on a line (4, 4A, 4B, 4C) of an electric network (1) to be monitored and comprising a device (100) for directional detection of a fault according to one of Claims 1 to 7 connected to said sensors (12, 12A, 12B, 12C, 14, 14A, 14B, 14C) in order to receive the signals representative of current and voltage.

9. Ground protection relay (9) comprising at least one fault passage indicator according to Claim 8 and means for actuating a disconnection device (5) in accordance with the results of the locating module (50) of the directional detection device (100) of the indicator.

10. Method for the directional detection (D, L) of a ground fault (10) in a multiphase network (1), comprising the triggering, once a signal (D) indicating the presence of said ground fault (10) has been obtained, of the directional determination (L) of the fault (10), said directional detection comprising the following steps:

    - obtaining signals representative of the homopolar voltage ($V_0$) and of the derivative in relation to time of the homopolar current ($dI_0/dt$);
    - evaluating, in relation to 180°, the phase shift between the signals representative of the homopolar voltage ($V_0$) and the derivative in relation to time of the homopolar current ($dI_0/dt$).

11. Directional detection method according to Claim 10, wherein the evaluation of the phase shift comprises the steps of:

> - determining the angle ($\beta$) between the signals representative of the homopolar voltage ($V_0$) and the derivative in relation to time of the homopolar current ($dI_0/dt$), or respectively of the complement ($\alpha$) to 180° of said angle ($\beta$);
> - comparing said angle ($\beta$), or respectively the complement ($\alpha$), with a fixed parameter in order to indicate whether the detected fault (D) is located downstream or upstream of the location at which the representative signals were obtained.

12. Directional detection method according to Claim 10, wherein the network has an isolated neutral, and wherein the evaluation in relation to 180° of the phase shift between the signals representative of the homopolar voltage ($V_0$) and of the derivative in relation to time of the homopolar current ($dI_0/dt$) comprises the steps of calculating the product ($\Pi$) between the signals representative of the homopolar voltage ($V_0$) and of the derivative in relation to time of the homopolar current ($dI_0/dt$) and comparing said product ($\Pi$) with zero.

13. Directional detection method according to one of Claims 10 to 12, wherein the signal (D) indicating the presence of a ground fault (10) is obtained by the comparison of the signal of homopolar voltage ($V_0$) to a fault detection threshold ($S_0$).

14. Directional detection method according to one of Claims 10 to 13, wherein signals representative of the homopolar voltage ($V_0$) and of the derivative in relation to time of the homopolar current ($dI_0/dt$) are obtained by sampling at a frequency below 1 kHz.

15. Method for protecting a current line (5) in the event of the appearance of a ground fault (10), comprising the actuation of a device (6) for disconnecting said line (5) if a ground fault (10) has been detected by a method according to one of Claims 10 to 14 downstream of said disconnection device (6).

**Fig.1**

**Fig.2A**

Fig.2B

Début

$V_A$, $V_B$, $V_C$

$V_{Af}$, $V_{Bf}$, $V_{Cf}$

$V_{Af}^*$, $V_{Bf}^*$, $V_{Cf}^*$

$V_{0f}^*$

$V_{0f}^* > S_0$ ?

D

$I_A$, $I_B$, $I_C$

$dI_A/dt$, $dI_B/dt$, $dI_C/dt$

$dI_{Af}/dt$, $dI_{Bf}/dt$, $dI_{Cf}/dt$

$dI_{Af}^*/dt$, $dI_{Bf}^*/dt$, $dI_{Cf}^*/dt$

$dI_{0f}^*/dt$

si neutre isolé

$\Pi = dI_{0f}^*/dt \times V_{0f}^*$

$\beta = $ angle $(dI_{0f}^*/dt, V_{0f}^*)$
$\alpha = 180° - \beta$

$\Pi < 0$

$|\alpha| < S_\alpha$ ?

Y

Y

N

N

L : défaut en AMONT

L : défaut en AVAL

Ouverture du disjoncteur 5
par le relai 8

Fig.3

16

**Fig.4**

## RÉFÉRENCES CITÉES DANS LA DESCRIPTION

**Documents brevets cités dans la description**

- EP 1475874 A
- EP 1890165 A
- FR 2936319
- WO 2006136520 A
- FR 2936378
- DE 19901789